# EUROPEAN PATENT SPECIFICATION

(11) **EP 2 789 017 B1**
(45) Date of publication and mention of the grant of the patent: **24.10.2018**
(21) Application number: 12854794.0
(22) Date of filing: 04.12.2012
(51) Int. Cl.: H01L 31/042, H01L 31/0224, H01L 31/18, H01L 31/068, H01L 31/0216

(54) **SOLAR CELL AND METHOD FOR PREPARING THE SAME**
SOLARZELLE UND DEREN HERSTELLUNGSVERFAHREN
CELLULE SOLAIRE ET PROCÉDÉ DE FABRICATION ASSOCIÉ

(30) Priority: 09.12.2011 KR 20110132202
(43) Date of publication of application: 15.10.2014
(73) Proprietor: Hanwha Chemical Corporation, Seoul 100-200 (KR)
(72) Inventor: SON, Won Il, Seoul 138-220 (KR); SIM, You Jin, Daejeon 305-748 (KR); KIM, Eui-Duk, Daejeon 305-720 (KR)
(74) Representative: Smaggasgale, Gillian Helen
(86) International application number: PCT/KR2012/010428
(87) International publication number: WO 2013/085248

(56) References cited:
- WO-A1-2008/134417
- DE-A1-102008 033 223
- DE-A1-102009 008 152
- JP-A- H10 107 306
- JP-A- 2004 193 337
- KR-A- 20020 059 189
- KR-A- 20110 018 648
- KR-A- 20110 101 218
- US-A1- 2009 223 549
- US-A1- 2010 154 875

## Description

### [Technical Field]

The present invention relates to a solar cell and a method for preparing the same. More specifically, the present invention relates to a solar cell that shows a low contact resistance and high efficiency and a method for preparing the same.

### [Background Art]

Recently, it is expected that conventional energy sources such as oil or coal will be exhausted, and interests in alternative energy are increasing. As one of the alternative energy, a solar cell, the next generation cell, uses a semiconductor device changing the solar energy directly to the electric energy, and thus it is in the center of attention. The solar cell is largely classified into a silicon solar cell, a compound semiconductor solar cell and a tandem solar cell, among which the silicon solar cell is the main stream.

On the other hand, a variety of means such as shallow emitter, selective emitter, etc. have been developed for the purpose of high efficiency of the silicon solar cell. The shallow emitter refers to an emitter layer having a high sheet resistance of 60 to 120 Ω/sq, which has the advantages of low recombination rate and using solar light having a short wavelength.

In the crystalline silicon solar cell, the emitter layer formed on a substrate makes a pn junction using the substrate as a base. The high Rs cell has the sheet resistance of 60 to 120 Ω/sq which is higher than 40 to 50 Ω/sq, the sheet resistance of the emitter layer of the earlier crystalline solar cell, and thus it shows excellent photoelectric transformation efficiency. In other words, the highly efficient solar cell gives the narrow dead layer (a region wherein the current formation from the produced electron is interrupted by the concentration of the excess semiconductor impurities) in the surface of the emitter layer formed on the front side of the solar cell substrate, which increases the solar cell efficiency.

The emitter layer of such highly efficient solar cells has the thickness of 100 nm to 500 nm, and the semiconductor impurity in the emitter layer may have the concentration of 1×10¹⁶ to 1×10²¹ atom/cm³. It can be made by forming the emitter to have such an ultra-slim thickness and by controlling the semiconductor impurities in the emitter layer to have a low doping concentration in the manufacturing process of the earlier solar cell.

However, the thickness of emitter layer in the conventional solar cell is 600 nm or more, whereas that of emitter layer in the highly efficient solar cell is ultra-slim such as 100 nm to 500 nm. Thus, when an electrode is formed in the highly efficient solar cell, it contacts with the base substrate through the thin emitter layer and thus has the problem of being easily short-circuited. That is, in order to commercially utilize the highly efficient solar cell comprising a thin emitter layer, a further step to make the contact of the electrode with the thin emitter layer easy and to prevent a short-circuit induced by the contact of the electrode with the base silicon substrate.

An Ag paste is used for forming the front side electrode of the thin emitter, and it contains silver powder, organic binder, glass frit, etc. However, due to the glass frit of the Ag paste, the ohmic contact property is poor, and even the short-circuit may occur in severe cases. In particular, forming the contact of the front side electrode requires a high temperature process of about 800 °C for a short duration. If this high temperature process is not adjusted correctly, high serial resistance and/or low shunt resistance will result.

One of the approaches for maintaining the merit of the thin emitter and solving the demerit thereof, there is disclosed a method wherein a nickel layer having a low contact resistance is incorporated and fired to form nickel silicide (Korean Patent Application No. 2010-7022607). In Korean Patent Application No. 2010-7022607, the method further anneals the electroless selective nickel layer with the n-doped portion for forming a nickel-silicide layer and electroplates a plurality of contacts on the nickel-silicide layer, thereby forming a low resistance contact path for the photovoltaic device. The method of above Literature 1 has such disadvantages that it is complicated due to the process of electroless plating for forming the nickel layer and the separate process of selective plating and that it costs a lot. Furthermore, the method should comprise an additional process to anneal the aluminum back surface of the solar cell device with the p-doped bulk silicon for establishing a more heavily p-doped region called BSF (Back Surface Field) which repulse the electrons towards the p-n junction.

JP2004193337 discloses a solar cell that is intended to be low-cost and efficiently performing through simplified steps, which enhances mechanical adhesion and electrical connection of plated electrodes. The method disclosed is said to involve forming electrodes for a solar cell on a semiconductor substrate by plating, and forming, by a heat treatment, layers of alloy comprising semiconductor metal and plating metal at interfaces between the semiconductor substrate and the plating electrode and between the semiconductor substrate and the electrode, respectively.

There is provided a method for increasing the potential difference at the p-n junction region by forming the selective emitter via the selective formation of a more heavily impurity-doped region on the top using the dopant paste of silicon substrate and for improving the short wavelength response to increase the efficiency of photovoltaic power (Korean Patent Application No. 2010-0068987). In the case of No. 2010-0068987, the method comprises the steps of incorporating and diffusing a second conductive type impurity into the silicon substrate to form a second conductive type semiconductor layer on the top of the silicon substrate; printing the silicon substrate surface with a dopant paste and heating it to form a more heavily doped region on the second conductive type semiconductor layer; etching the silicon substrate surface using the dopant paste as a barrier; removing the dopant paste which is printed on the silicon substrate surface and patterning a metal material to contact with the more heavily doped region, thereby forming an electrode; and progressing an additional diffusion process for extending the more heavily doped region. However, even this method is complicated and costs a lot.

### [Disclosure]

### [Technical Problem]

In order to solve the above mentioned problems of the prior arts, an object of the present invention is to provide a solar cell having a low contact resistance.

Another object of the present invention is to provide a method for preparing a solar cell.

### [Technical Solution]

For achieving the above object, the present invention provides a solar cell which comprises:
a first conductive type substrate;
a second conductive type emitter layer which is located on the substrate and has a first opening;
an anti-reflective film which is located on the emitter layer and has a second opening communicating with the first opening;
a first electrode which fills the first opening and comprises phosphorus and nickel silicide;
a second electrode which is formed on the first electrode, fills the second opening and comprises phosphorus and nickel;
a front side electrode which is formed on the second electrode; and
a back side electrode which is located on the rear side of the substrate,
wherein the first opening exposes 5 to 10 nm of a thickness of the emitter layer,
wherein the emitter layer contains phosphorus as an impurity, and the first electrode contains phosphorus in a higher concentration than the emitter layer.

Also, the present invention provides a method for preparing a solar cell which comprises the steps of:
forming a second conductive type emitter layer on a top of a first conductive type substrate;
forming a anti-reflective film on a top of the emitter layer;
removing parts of the anti-reflective film and the emitter layer to form a first opening which exposes a part of the emitter layer and a second opening which communicates with the first opening and exposes a part of the anti-reflective film;
screen-printing a phosphorus-doped nickel nanoparticle-containing paste in the first and second openings and heating it to form first and second electrodes in the first and second openings, respectively;
screen-printing a silver paste on the second electrode and heating it to form a front side electrode; and
printing an aluminum paste on a rear side of the substrate and heating it to form a back side electrode,
wherein the emitter layer contains phosphorus as an impurity, and the first electrode contains phosphorus in a higher concentration than the emitter layer.

### [Advantageous Effects]

The present invention can provide a solar cell and a method for preparing the same, whereby a low contact resistance can be provided to increase the efficiency of photovoltaic power.

### [Description of Drawings]

Figure 1 is a cross-sectional view illustrating the structure of a solar cell according to one embodiment of the present invention.
Figures 1a to 1e are drawings briefly illustrating the procedure of preparing a solar cell according to one embodiment of the present invention.
Figure 2 is a photograph of the cross-section of a silicon-nickel interface formed according to Experimental Example 1, which is enlarged by Scanning Electron Microscopy (SEM).
Figure 3 is a graph illustrating the analysis result of a silicon-nickel interface formed according to Experimental Example 1 by EDX analysis method.
Figure 4 is a graph illustrating the analysis result of a silicon-nickel interface formed according to Experimental Example 2 by EDX analysis method.
Figure 5 is a graph illustrating the analysis result of a silicon-nickel interface formed according to Comparative Experimental Example 1 by EDX analysis method.
Figure 6 is a graph illustrating the firing temperature-dependent sheet resistance of the sheets formed according to Experimental Example 3 and Comparative Experimental Example 2.

### [Best Mode]

The solar cell according to one embodiment of the present invention comprises a first conductive type substrate; a second conductive type emitter layer which is located on the substrate and has a first opening; an anti-reflective film which is located on the emitter layer and has a second opening communicating with the first opening; a first electrode which fills the first opening and comprises phosphorus and nickel silicide; a second electrode which is formed on the first electrode, fills the second opening and comprises phosphorus and nickel; a front side electrode which is formed on the second electrode; and a back side electrode which is located on the rear side of the substrate.

Also, the method for preparing a solar cell according to one embodiment of the present invention comprises the steps of forming a second conductive type emitter layer on a top of a first conductive type substrate; forming a anti-reflective film on a top of the emitter layer; removing parts of the anti-reflective film and the emitter layer to form a first opening which exposes a part of the emitter layer and a second opening which communicates with the first opening and exposes a part of the anti-reflective film; screen-printing a phosphorus-doped nickel nanoparticle-containing paste in the first and second openings and heating it to form first and second electrodes in the first and second openings, respectively; screen-printing a silver paste on the second electrode and heating it to form a front side electrode; and printing a aluminum paste on a rear side of the substrate and heating it to form a back side electrode.

In the present invention, the terms "first," "second," etc. are used for illustrating the various components, and said terms are used only for the purpose of distinguishing one component from the other.

Also, when each layer or component is stated as being formed on the "top" or "above" of each layers or components in the present invention, it means that said each layer or component is formed directly on each layers or components, or other layer or component may be additionally formed between each layers, or on subjects or substrates.

The present invention may be modified in various ways or may have various forms. Thus, specific examples are to be exemplified and explained in detail below. However, it is not intended that the scope of the present invention is limited in any manner by the specific disclosures, and it should be understood that all the modifications, equivalents or replacements are to fall within the technical concept and scope of the present invention.

Hereinafter, the solar cell of the present invention and the method for preparing the same will be explained more in detail by referring to the drawings.

### Solar Cell

The solar cell of the present invention comprises:
a first conductive type substrate;
a second conductive type emitter layer which is located on the substrate and has a first opening;
an anti-reflective film which is located on the emitter layer and has a second opening communicating with the first opening;
a first electrode which fills the first opening and comprises phosphorus and nickel silicide;
a second electrode which is formed on the first electrode, fills the second opening and comprises phosphorus and nickel;
a front side electrode which is formed on the second electrode; and
a back side electrode which is located on the rear side of the substrate.

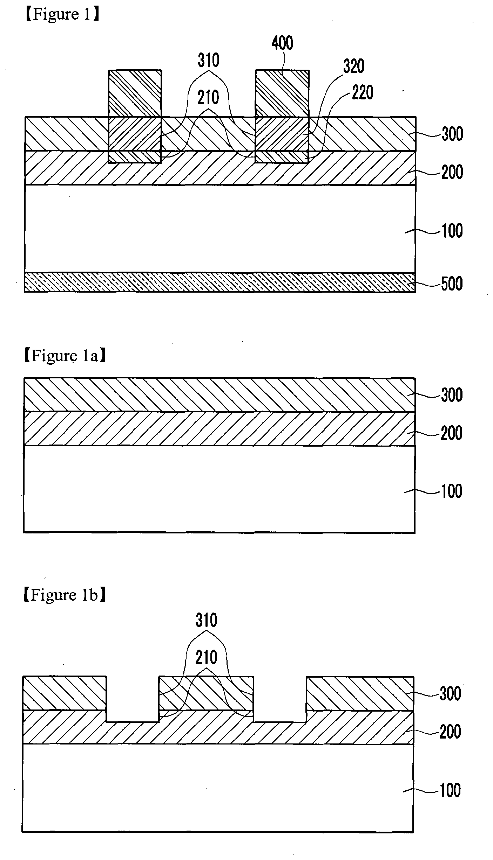

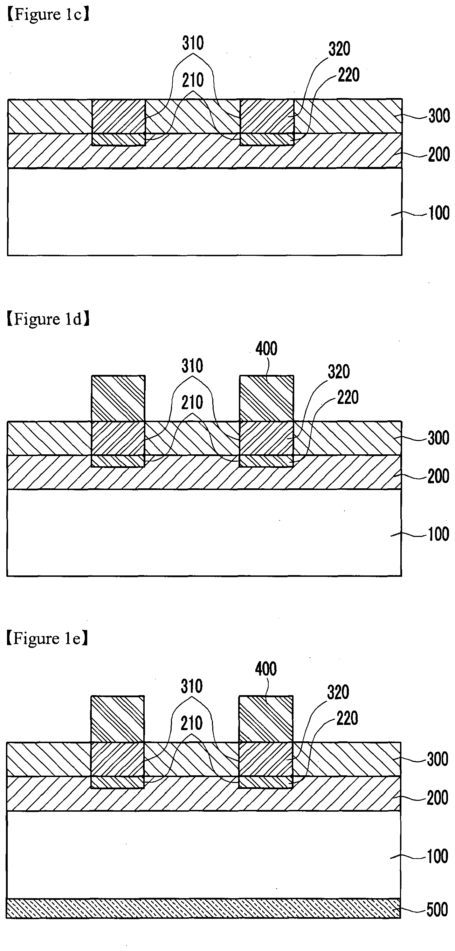

Figure 1 is a cross-sectional view illustrating the structure of the solar cell according to one embodiment of the present invention.

Referring to Figure 1, the solar cell according to the present invention comprises a first conductive type substrate (100); a second conductive type emitter layer (200) which is located on the substrate (100) and has a first opening (210); a anti-reflective film (300) which is located on the emitter layer (200) and has a second opening (310) communicating with the first opening (210); a first electrode (220) which fills the first opening (210) and comprises phosphorus and nickel silicide; a second electrode (320) which is formed on the first electrode (220), fills the second opening (310) and comprises phosphorus and nickel; a front side electrode (400) which is formed on the second electrode (320); and a back side electrode (500) which is located on a rear side of the substrate (100).

According to one embodiment of the present invention, the substrate (100) is a first conductive type silicon semiconductor substrate, and may be doped with impurities of trivalent elements such as boron (B), gallium (Ga), indium (In), etc. as a P-type impurity, for example. The silicon may be a crystalline silicon such as monocrystalline silicon or polycrystalline silicon, or an amorphous silicon.

The emitter layer (200) is a second conductive type, which is opposite to the substrate (100), and may be doped with impurities of Group V elements such as phosphorus (P), arsenium (As), antimony (Sb), etc. as a N-type impurity.

According to another embodiment of the present invention, the substrate (100) may be N-type conductive type, and the emitter layer (200) may be P-type conductive type.

If the opposite conductive type impurities are doped in the substrate (100) and the emitter layer (200) as above, a P-N junction is formed in an interface between the substrate (100) and the emitter layer (200).

According to one embodiment of the present invention, the emitter layer (200) may have a high sheet resistance of which photovoltaic conversion efficiency is high. For example, the solar cell of the present invention may comprise the emitter layer (200) whose sheet resistance is as high as about 60 to about 120 Ω/sq.

According to one embodiment of the present invention, the emitter layer (200) may have a thickness of about 100 to about 500 nm.

Referring to Figure 1, the emitter layer (200) has the first opening (210) which exposes at least a part of the emitter layer (200), for example, about 5 to about 10 nm of a thickness of the emitter layer (200).

The anti-reflective film (300) plays a role of passivating a defect that exists on a surface of or in a bulk of the emitter layer (200) and reducing reflectivity of a incident solar light on a front surface of the substrate (100). If a defect of the emitter layer (200) is passivated, a recombination site of a hydrophobic carrier is removed to increase an open-circuit voltage (Voc) of the solar cell. And, as solar reflectivity decreases, an amount of light reaching the P-N junction increases and then a short-circuit current (Isc) of the solar cell increases. Accordingly, a conversion efficiency of the solar cell increases as much as increases in the open-circuit voltage and the short-circuit current of the solar cell by the anti-reflective film (300).

The anti-reflective film (300) may have, for example, a monolayered structure of any one selected from the group consisting of a silicon nitride film, a silicon nitride film including hydrogen, a silicon oxide film, a silicon oxide nitride film, MgF₂, ZnS, TiO₂ and CeO₂, or a multilayered structure wherein two or more layers are combined, but is not limited thereto. Furthermore, a thickness of the anti-reflective film (300) may be about 30 to about 100 nm, but is not limited thereto.

The anti-reflective film (300) is located on the top of the emitter layer (200) and has the second opening (310) which communicates with the first opening (210). Thus, the second opening (310) becomes to have the shape penetrating the anti-reflective film (300).

The first and second openings (210, 310) may have the width of about 20 to about 150 µm and they may have any shape. For example, the first and second openings (210, 310) may have a shape of circle, ellipse, square or triangle.

The first electrode (220) and the second electrode (320) are formed with filling the first opening (210) and the second opening (310), respectively.

The first electrode (220) fills the first opening (210) with contacting the emitter layer (200) which is exposed by the first opening (210), and comprises phosphorus and nickel silicide (Ni silicide).

The content of phosphorus in the first electrode (220) is higher than the concentration of phosphorus doped in the emitter layer (200) as an impurity, and may range from about 1 to about 20 wt%, preferably from about 5 to about 15 wt%.

The first electrode (220) may be formed to comprise phosphorus and nickel silicide by using a phosphorus-doped nickel nanoparticle.

The nickel contained in the above phosphorus-doped nickel nanoparticle may react with the silicon in the emitter layer (200) to form nickel silicide in the interface of the emitter layer (200), whereby the first electrode (220) comprises nickel silicide. Thus, a low contact resistance may be provided to increase the efficiency of the photovoltaic power.

The second electrode (320) is formed on the first electrode (220), fills the second opening (310) and comprises phosphorus and nickel. The phosphorus-doped nickel nanoparticle used in the formation of the second electrode (320) may be the same as the nickel particle used in the formation of the first electrode (220). However, since the second electrode (320) does not contact with the emitter layer (200), nickel silicide is not formed.

The front side electrode (400) is formed on the second electrode (320) and has a shape that extrudes from the anti-reflective film (300).

According to one embodiment of the present invention, the front side electrode (400) contains silver (Ag), and in particular may contain no glass frit. Since the front side electrode (400) contains no glass frit, the risk of short-circuit and the increase of contact resistance due to the glass frit as a non-conductive material, i.e., risk of conductivity decrease, may be reduced to improve reliability.

According to one embodiment of the present invention, the front side electrode (400) may have the width of about 40 to about 200 µm and the height of about 5 to about 30 µm.

The back side electrode (500) is formed on the rear side of the substrate (100) and may contain aluminum. The aluminum contained in the back side electrode (500) may diffuse through the rear side of the substrate (100) to form a back surface field layer in the interface between the back side electrode (500) and the substrate (100). If the back surface field layer is formed, it may be prevented that the carrier moves to the rear side of the substrate (100) and recombine therewith. If the carrier recombination is prevented, the open circuit voltage may increase to improve the efficiency of the solar cell.

The efficiency of the solar cell according to the present invention may be improved by the provision of a low contact resistance, which is achieved by the features that the solar cell is formed by using the highly concentrated phosphorus-doped nickel nanoparticle, it comprises the first electrode contacting the emitter layer to selectively form the highly concentrated impurity-doped region, and at the same time it comprises nickel silicide in the contact between the emitter layer and the first electrode.

### Method for Preparing A Solar Cell

The method for preparing the solar cell of the present invention comprises the steps of:
forming a second conductive type emitter layer on a top of a first conductive type substrate;
forming an anti-reflective film on a top of the emitter layer;
removing parts of the anti-reflective film and the emitter layer to form a first opening which exposes a part of the emitter layer and a second opening which communicates with the first opening and exposes a part of the anti-reflective film;
screen-printing a phosphorus-doped nickel nanoparticle-containing paste in the first and second openings and heating it to form first and second electrodes in the first and second openings, respectively;
screen-printing a silver paste on the second electrode and heating it to form a front side electrode; and
printing a aluminum paste on a rear side of the substrate and heating it to form a back side electrode.

Figures la to 1e briefly summarize the procedure of preparing the solar cell according to one embodiment of the present invention.

Referring to Figure 1a, first, the first conductive type substrate (100) is prepared.

In the substrate (100), the Group III elements of B, Ga, In, etc. may be doped as a P-type impurity.

An emitter layer (200) is formed on the top of the substrate (100). In the emitter layer (200), the Group V elements of P, As, Sb, etc. may be doped as a N-type impurity. The emitter layer (200) may be formed in a thickness of about 100 to about 500 nm.

According to one embodiment of the present invention, a P-containing substance such as POCl₃ may be provided as a gas or liquid phase and doped on the surface of the substrate (100) by a thermal diffusion method in the constant thickness to form the emitter layer (200) having a sheet resistance of 60 to 120 Ω/sq.

Then, an anti-reflective film (300) is formed on the top of the emitter layer (200).

The anti-reflective film (300) may be formed by vacuum deposition, chemical vapor deposition, spin coating, screen printing or spray coating, but the method is not limited thereto. Also, the anti-reflective film (300) may have, for example, a monolayered structure of any one selected from the group consisting of a silicon nitride film, a silicon nitride film including hydrogen, a silicon oxide film, a silicon oxide nitride film, MgF₂, ZnS, TiO₂ and CeO₂, or a multilayered structure wherein two or more layers are combined, but is not limited thereto.

The anti-reflective film (300) may be formed to have a thickness of about 30 to about 100 nm.

Referring to Figure 1b, there are formed a first opening (210) which penetrates the anti-reflective film (300) with removing the same and at the same time removes a part of the emitter layer (200) with exposing a part thereof, and a second opening (310) which communicates with the first opening (210) with exposing the anti-reflective film (300).

The first and second openings (210, 310) may be formed via patterning using any known method selected from a photolithography, an optical scribing method, a mechanical scribing method, an etching method using plasma, a wet-type etching method, a dry-type etching method, a lift-off method, and a wire mask method. According to one embodiment of the present invention, the first and second openings (210, 310) may be formed by removing a constant size using a laser ablation method, but the method is not limited thereto.

The second opening (310) completely penetrates the anti-reflective film (300). However, the first opening (210) does not penetrate the emitter layer (200) and may be formed in the depth as much as the thickness removed from the emitter layer (200). The first opening (210) is formed by removing the emitter layer (200) in the depth of about 5 to about 10 nm.

The first and second openings (210, 310) may have the width of about 20 to about 150 µm and they may have any shape. For example, the first and second openings (210, 310) may be formed in the shape of circle, ellipse, square or triangle.

Next, referring to Figure 1c, a phosphorus-doped nickel nanoparticle-containing paste is screen-printed on the first and second openings (210, 310) and then heated.

The phosphorus-doped nickel nanoparticle-containing paste may comprise 60 to 95 parts by weight of the phosphorus-doped nickel nanoparticle, 1 to 20 parts by weight of a binder and 1 to 20 parts by weight of a solvent, based on 100 parts by weight of the paste.

The above phosphorus-doped nickel nanoparticle used for forming the first and second electrodes (220, 320) have the average particle diameter of about 5 to about 200 nm, preferably about 10 to about 100 nm, and may contain phosphorus in the amount of about 1 to about 20 wt%.

The phosphorus-doped nickel nanoparticle may be prepared by a semi-continuous process in a liquid phase reduction method, but the method is not limited thereto.

For example, for a transition metal nucleus particle as a catalyst for growing nickel, a nickel solution containing a nickel precursor and a solvent is mixed with a phosphorus-containing reducing agent to reduce the nickel and concurrently make the phosphorus doped, whereby the nickel nanoparticle having a nano-scale particle diameter wherein phosphorus is doped in the amount of 1 to 20 wt% can be obtained.

The phosphorus-doped nickel nanoparticle may be contained in the amount of 60 to 95 parts by weight based on 100 parts by weight of the paste. Sufficient conductivity is not achieved when the nickel nanoparticle is contained in the amount of less than 60 parts by weight, and the viscosity becomes too high to make the screen printing easy when it is contained in the amount of exceeding 95 parts by weight.

The binder acts as a binding material of each ingredient before the firing of electrode pattern, and it is preferably prepared by a suspension polymerization for obtaining homogeneity. The binder may include a carboxyl group-containing resin, specifically, a carboxyl group-containing photosensitive resin having the ethylenic unsaturated double bond in itself and a carboxyl group-containing resin not having the ethylenic unsaturated double bond.

According to one embodiment of the present invention, a carboxyl group-containing resin obtained by copolymerizing an unsaturated carboxylic acid and a compound having an unsaturated double bond, a carboxyl group-containing photosensitive resin obtained by adding an ethylenic unsaturated group as a pendant to a copolymer of an unsaturated carboxylic acid and a compound having an unsaturated double bond, or a carboxyl group-containing photosensitive resin obtained by reacting a copolymer of an acid anhydride having an unsaturated double bond and a compound having an unsaturated double bond with a compound having hydroxy group and an unsaturated double bond may be used, but the binder is not limited thereto.

The binder is preferably contained in the amount of 1 to 20 parts by weight. The binder distribution in the electrode pattern thus formed may become heterogeneous to make the patterning by the selective exposure and development difficult when the content of the binder is less than 1 part by weight, and the pattern disruption may easily occur at the time of firing the electrode and the electrode resistance may increase by the carbon ash after the firing when the content exceeds 20 parts by weight.

Any solvent that can dissolve the binder and be mixed well with other additives may be used. Unlimited examples of the solvent include a-terpinol, butyl carbitol acetate, texanol, butyl carbitol, di-propylene glycol monomethyl ether, etc.

It is preferable that the solvent is contained in the amount of 1 to 20 parts by weight. It is not easy to apply the paste homogeneously when the solvent is contained in the amount of less than 1 part by weight. On the contrary, when the solvent is contained in the amount of exceeding 20 parts by weight, sufficient conductivity of the electrode pattern is not achieved and the adhesion to the substrate may be deteriorated.

Additives such as dispersing agent, thickening agent, thixotropic agent, leveling agent, etc. may be further contained, and their amounts may be 1 to 20 parts by weight based on 100 parts by weight of the paste.

According to one embodiment of the present invention, the step of screen-printing the phosphorus-doped nickel nanoparticle-containing paste and then heating it may be carried out in the manner that printing is done by using a screen printer before it is fired for about 10 sec to about 20 min in a belt firing of about 400 to about 900 °C under nitrogen atmosphere. It may be difficult to form the impurity-doped region having a higher impurity concentration than the emitter layer (200) when the temperature of heat treatment is less than 400 °C, and nickel silicide may not be formed when the temperature is too high.

The first electrode (220) is formed in the first opening (210) by printing the phosphorus-doped nickel nanoparticle-containing paste and heating it as above. Also, the second electrode (320) is formed in the second opening (310).

Through the process of screen-printing the phosphorus-doped nickel nanoparticle-containing paste and firing it, the phosphorus-doped nickel nanoparticle in the first electrode (220) may react with the silicon in the emitter layer (200) contacted with the first electrode to form nickel silicide in the interface with the emitter layer (200). Thus, the first electrode (220) contains phosphorus and nickel silicide. Also, the first electrode (220) forms the higher concentrated impurity-doped region than the emitter layer (200) due to the phosphorus contained in the phosphorus-doped nickel nanoparticle and thus provides a low contact resistance.

By the firing, the second electrode (320) contains phosphorus and nickel. Since the second electrode (320) does not contact with the emitter layer (200), nickel silicide is not formed. The second electrode (320) may fill the second opening (310) completely, being formed to the same height as the anti-reflective film (300).

Next, referring to Figure Id, the silver (Ag) paste is screen-printed on the second electrode (320) and then heated to form the front side electrode (400).

The front side electrode (400) is connected with the second electrode (320) with being formed on the top thereof.

The silver paste contains the silver powder in the amount of about 60 to about 95 parts by weight based on 100 parts by weight of the total silver paste. The front side electrode (400) cannot have sufficient conductivity when the content of silver powder is less than 60 parts by weight, whereas viscosity is too high to make the printing easy when the content exceeds 95 parts by weight, and thus the content beyond the above range is not desirable.

According to one embodiment of the present invention, the silver paste may not contain the glass frit. The glass frit plays a role of adhering or combining the silver paste on the substrate after firing, but it is also a factor causing the short-circuit under the high temperature during the firing. In the method of the present invention, the silver paste not containing the glass frit is used in the formation of the front side electrode (400), whereby the risk of short-circuit and the risk of contact resistance increase due to the glass frit as a non-conductive material may be reduced even under a high temperature process. Thus, the reliability of the solar cell may be improved.

According to one embodiment of the present invention, the step of screen-printing the silver paste and heating it may be carried out in the manner that printing is done by using a screen printer before the paste is fired for about 10 sec to about 20 min in a belt firing of about 400 to about 900 °C under nitrogen atmosphere.

The front side electrode (400) may be formed to have the width of about 40 to about 200 µm and the height of about 5 to about 30 µm.

According to one embodiment of the present invention, the step of screen-printing the phosphorus-doped nickel nanoparticle-containing paste and then heating it for forming the first and second electrodes (220, 320) and the step of screen-printing the silver paste and then heating it for forming the front side electrode (400) may be carried out simultaneously. In other words, the nickel paste and the silver paste are screen-printed and then heated at one time to form the first electrode (220), the second electrode (320) and the front side electrode (400) simultaneously. In this case, the heat treatment may be performed by firing for about 10 sec to about 20 min in a belt firing of about 400 to about 900 °C under nitrogen atmosphere.

According to other embodiment of the present invention, the heat treatment of the nickel paste and that of the silver paste may be performed separately.

Referring to Figure 1e, the aluminum paste is printed on the rear side of the substrate (100) and then heated to form the back side electrode (500).

The aluminum paste may comprise aluminum, quartz silica, binder, etc. During the heat treatment of the aluminum paste, the aluminum may diffuse through the rear side of the substrate (100) to form the back surface field layer in the interface between the back side electrode (500) and the substrate (100). If the back surface field layer is formed, it may be prevented that the carrier moves to the rear side of the substrate (100) and recombine therewith. If the carrier recombination is prevented, the open circuit voltage may increase to improve the efficiency of the solar cell.

According to one embodiment of the present invention, the step of heat treatment of the aluminum past may be performed by firing for about 10 sec to about 20 min in a belt firing of about 400 to about 900 °C under nitrogen atmosphere.

Although it is not illustrated by a separate drawing, according to other embodiment of the present invention, the back side electrode (500) may be formed simultaneously with the step of forming the front side electrode (400). In other words, the silver paste for the formation of the front side electrode (400) is screen-printed and the aluminum paste for the formation of the back side electrode (500) is screen-printed and then the front side electrode (400) and the back side electrode (500) may be formed simultaneously by the firing process.

Furthermore, according to other embodiment of the present invention, the back side electrode (500) may be formed by a separate firing process after the formation of the anti-reflective film (300) and before the formation of the first and second openings (210, 310). These various methods for forming the back side electrode (500) do not exert any influence on the performance of the solar cell of the present invention.

### [Mode for Invention]

Hereinafter, the present invention will be explained more in detail by the Examples. However, the following Examples are only for the illustration of the present invention and it is not intended that the scope of the present invention is limited in any manner by them.

### <Preparation Examples>

### Preparation of a phosphorus-doped nickel nanoparticle-containing paste

### Preparation Example 1

85 wt% of the powder of the phosphorus-doped nickel nanoparticle whose average particle diameter was 100 nm and phosphorus content was 17.45 wt%, 10 wt% of butyl carbitol acetate and 5 wt% of ethyl cellulose resin (Trade name: Ethocel, Dow Company, Standard 100) as a binder were mixed and dispersed. The mixture dispersion was dispersed by 3-roll milling to prepare the desired paste.

### Preparation Example 2

The desired paste was prepared according to the same procedure as Preparation Example 1 except that the doped nickel nanoparticle whose average particle diameter was 100 nm and phosphorus content was 15.68 wt% was used.

### Comparative Preparation Example 1

The desired paste was prepared according to the same procedure as Preparation Example 1 except that the nickel nanoparticle not doped with phosphorus (Dream Corporation, Code No. DR-NIM-04) whose average particle diameter was 80 nm was used.

### <Examples>

### Preparation of a solar cell

### Example 1

Phosphorus (P) was doped via a diffusion process using POCl₃ in a tube furnace of 900 °C wherein the 156 mm polycrystalline silicon wafer was utilized to form an emitter layer having the sheet resistance of 100 Ω/sq.

On the above emitter layer, a silicon nitride film was vapor-deposited in the thickness of 80 nm via the PECVD method to form an anti-reflective film.

Al paste (Toyo Aluminium K. K Company ALSOLAR) was screen-printed on the rear side. Then, it was dried in a belt firing of 300 °C for 60 sec and fired in a belt firing of 900 °C for 60 sec. After firing, the back side electrode was formed in the thickness of about 30 µm.

The anti-reflective film was removed in the width of 40 µm by laser ablation to form an opening. The paste obtained in Preparation Example 1 was screen-printed on this opening to form a nickel layer.

A front side electrode was formed by using the Ag paste not containing the glass frit (FP Inc., FTL-602) on the nickel layer as formed above. Subsequently, firing in a belt firing of 900 °C was performed for 20 sec to form the first electrode, the second electrode and the front side electrode. The width of finger fired was about 80 µm, and the thickness of the front side electrode fired was about 10 µm.

### Example 2

The desired solar cell was prepared according to the same procedure as Example 1 except that firing was performed in a belt firing of 800 °C for 20 sec in the formation of the first electrode, the second electrode and the front side electrode.

### Comparative Example 1

The desired solar cell was prepared according to the same procedure as Example 1 except that the paste obtained in Comparative Preparation Example 1 was used.

### <Experimental Example>

### 1. Evaluation of nickel silicide formation

### Experimental Example 1

In order to confirm that phosphorus was diffused into the pure Si wafer by the firing of the phosphorus-doped nickel particle, a wafer not doped with any impurity was prepared.

The paste obtained in Preparation Example 1 was printed on the above wafer using a screen printer and fired in a belt firing of 900 °C for 20 sec under nitrogen atmosphere.

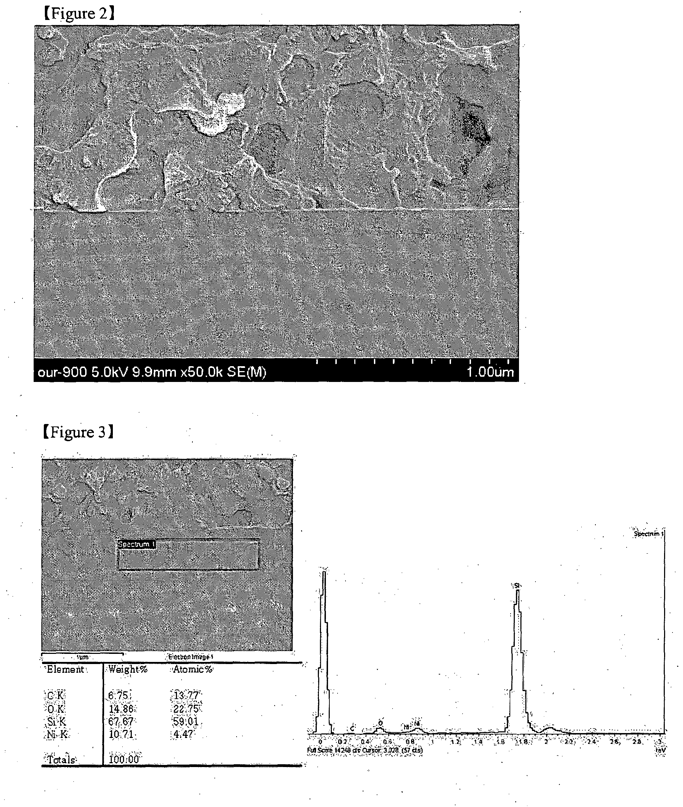

The cross-section thus formed was analyzed by SEM (Scanning Electron Microscopy), and the result is shown in Figure 2.

Also, the interface was analyzed by EDX (Energy Dispersive X-ray microanalysis), and the result is shown in Figure 3.

Referring to Figures 2 and 3, it is confirmed that the nickel ingredient is detected in the top part of the pure Si wafer below the interface, whereby it can be confirmed that nickel silicide was formed in the region of silicon-nickel contact layer.

### Experimental Example 2

Firing was performed according to the same procedure as Experimental Example 1 except that the paste obtained in Preparation Example 2 was used.

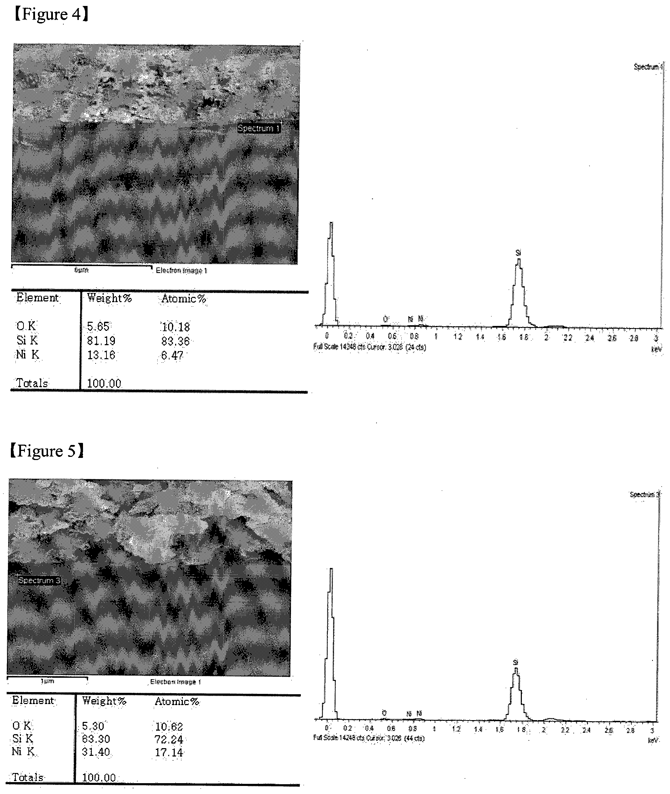

The result obtained from the analysis of the interface by EDX is shown in Figure 4. Referring to Figure 4, it is confirmed that the nickel ingredient is detected in the top part of the pure Si wafer below the interface, whereby it can be confirmed that nickel silicide was formed in the region of silicon-nickel contact layer.

### Comparative Experimental Example 1

Firing was performed according to the same procedure as Experimental Example 1 except that the paste obtained in Comparative Preparation Example 1 was used.

The result obtained from the analysis of the interface by EDX is shown in Figure 5. Referring to Figure 5, it is confirmed that the nickel ingredient is detected in the top part of the pure Si wafer below the interface, whereby it can be confirmed that nickel silicide was formed in the contact layer.

### 2. Evaluation of sheet resistance

### Experimental Example 3

Phosphorus (P) was doped via a diffusion process using POCl₃ in a tube furnace of 900 °C wherein a pure polycrystalline silicon wafer was utilized, and a wafer having the sheet resistance of 75 Ω/sq was used.

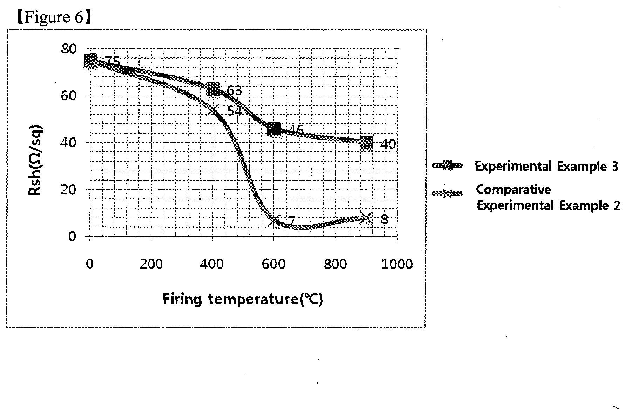

Next, the paste obtained in Preparation Example 1 was printed on the above wafer using a screen printer and fired in a belt firing of 400, 600, 900 °C for 20 sec under nitrogen atmosphere. After firing at each temperature, the sheet resistance was measured by a 4-probe meter. The results are shown in Table 1 and Figure 6.

### Comparative Experimental Example 2

Phosphorus (P) was doped via a diffusion process using POCl₃ in a tube furnace of 900 °C wherein a pure polycrystalline silicon wafer was utilized, and a wafer having the sheet resistance of 75 Ω/sq was used.

Next, the paste obtained in Comparative Preparation Example 1 was printed on the above wafer using a screen printer and fired in a belt firing of 400, 600, 900 °C for 20 sec under nitrogen atmosphere. After firing at each temperature, the sheet resistance was measured by a 4-probe meter. The results are shown in Table 1 and Figure 6.

**[Table 1]**

| | Content of Phosphorus Doped in the Nickel Particle | Average Particle Diameter of the Nickel Particle | Formation of Ni silicide | Sheet Resistance | | |
|---|---|---|---|---|---|---|
| | | | | Firing at 400°C | Firing at 600°C | Firing at 900°C |
| Experimental Example 3 | 17.45 wt% | 100 nm | Formed | 54 Ω/sq | 7 Ω/sq | 8 Ω/sq |
| Comparative Experimental Example 2 | 0 | 80 nm | Formed | 63 Ω/sq | 46 Ω/sq | 40 Ω/sq |

Referring to Table 1 and Figure 6, nickel silicide is formed in both of Experimental Example3 and Comparative Experimental Example2. However, it can be confirmed that the sheet resistance is lower in Experimental Example3. This is because an electrode is formed using a paste containing the phosphorus-doped nickel nanoparticle on the emitter layer, whereby a highly concentrated phosphorus-doped region is formed and at the same time nickel silicide is formed to give a low contact resistance.

In particular, it can be confirmed that the sheet resistance depending on the firing temperature is lower in Experimental Example 3 than in Comparative Experimental Example2.

### 3. Evaluation of electric performance of the solar cell

The electric performances of the solar cells prepared in Examples 1, 2 and Comparative Example 1 were measured according to ASTM G-173-03 under the solar condition of AM 1.5 using a solar tester (Model NCT-M-180A from NPC Incorporated located in Dumont NJ USA).

The results are shown in Table 2. Here, Jsc means the short-circuit current density measured at zero output voltage, Voc means the open circuit voltage measured at zero output current, and the series resistance (RS) means the resistance acting in series between the top electrode and the bottom electrode of the solar cell. The composition of the contact interface and the microstructure determine the RS. FF [%] means the fill factor and Eta [%] means the efficiency.

**[Table 2]**

| | Jsc [mA/cm2] | Voc [V] | FF [%] | Rs[mΩ] | Eta [%] |
|---|---|---|---|---|---|
| Example 1 | 36.29 | 0.615 | 76.49 | 481 | 17.30 |
| Example 2 | 34.90 | 0.618 | 75.56 | 615 | 16.83 |
| Comparative Example 1 | 34.39 | 0.616 | 73.42 | 940 | 15.94 |

As can be seen from the results of Table 2, if the phosphorus-doped nickel particle is used, the series resistance (RS) is decreased to increase the fill factor and ultimately increase the efficiency of the solar cell.

### [Definition of symbols]

100: Substrate
200: Emitter Layer
210: First Opening
220: First Electrode
300: Anti-Reflective Film
310: Second Opening
320: Second Electrode
400: Front Side Electrode
500: Back Side Electrode

## Claims

1. A solar cell which comprises:
a first conductive type substrate (100);
a second conductive type emitter layer (200) which is located on the substrate and has a first opening (210);
an anti-reflective film (300) which is located on the emitter layer and has a second opening (310) communicating with the first opening;
a first electrode (220) which fills the first opening and comprises phosphorus and nickel silicide;
a second electrode (320) which is formed on the first electrode, fills the second opening and comprises phosphorus and nickel;
a front side electrode (400) which is formed on the second electrode, and contains silver (Ag); and
a back side electrode (500) which is located on the rear side of the substrate,
wherein the first opening exposes 5 to 10 nm of a thickness of the emitter layer,
wherein the emitter layer contains phosphorus as an impurity, and the first electrode contains phosphorus in a higher concentration than the emitter layer.

2. The solar cell according to Claim 1, wherein the emitter layer (200) has the sheet resistance of 60 to 120 Ω/sq and the thickness of 100 to 500 nm.

3. The solar cell according to Claim 1, wherein the back side electrode (500) contains aluminum.

4. A method for preparing a solar cell, which comprises the steps of
forming a second conductive type emitter layer (200) on the top of a first conductive type substrate (100); forming an anti-reflective film (300) on the top of the emitter layer; removing parts of the anti-reflective film and the emitter layer to form a first opening (210) which exposes 5 to 10 nm of a thickness of the emitter layer and a second opening (310) which communicates with the first opening and exposes a part of the anti-reflective film;
screen-printing a phosphorus-doped nickel nanoparticle-containing paste in the first and second openings and heating it to form first (220) and second electrodes (320) in the first and second openings, respectively, wherein the first electrode comprises phosphorus and nickel silicide and the second electrode comprises phosphorus and nickel;
screen-printing a silver paste on the second electrode and heating it to form a front side electrode (400) containing silver (Ag); and printing an aluminum paste on the rear side of the substrate and heating it to form a back side electrode (500), wherein the emitter layer contains phosphorus as an impurity, and the first electrode contains phosphorus in a higher concentration than the emitter layer.

5. The method for preparing a solar cell according to Claim 4, wherein the phosphorus-doped nickel nanoparticle-containing paste comprises 60 to 95 parts by weight of the phosphorus-doped nickel nanoparticle, 1 to 20 parts by weight of a binder and 1 to 20 parts by weight of a solvent, based on 100 parts by weight of the paste.

6. The method for preparing a solar cell according to Claim 5, wherein the phosphorus-doped nickel nanoparticle has the average particle diameter of 5 to 200 nm.

7. The method for preparing a solar cell according to Claim 5, wherein the phosphorus-doped nickel nanoparticle contains phosphorus in the amount of 1 to 20 wt% based on the total weight of the nickel nanoparticle.

8. The method for preparing a solar cell according to Claim 4, wherein the silver paste does not contain a glass frit.

9. The method for preparing a solar cell according to Claim 4, wherein the emitter layer (200) has the sheet resistance of 60 to 120 Ω/sq and the thickness of 100 to 500 nm.

10. The method for preparing a solar cell according to Claim 4, wherein the step of heat treatment of the phosphorus-doped nickel nanoparticle-containing paste and the step of heat treatment of the silver paste are performed simultaneously.

11. The method for preparing a solar cell according to Claim 10, wherein the step of heat treatment is performed by firing for 10 sec to 20 min at the temperature of 400 to 900°C.

## Patentansprüche

1. Solarzelle, die Folgendes umfasst:
ein Substrat (100) eines ersten Leitfähigkeitstyps;
eine Emitterschicht (200) eines zweiten Leitfähigkeitstyps, die auf dem Substrat angeordnet ist und eine erste Öffnung (210) aufweist;
einen Antireflexionsfilm (300), der auf der Emitterschicht angeordnet ist und eine zweite Öffnung (310) aufweist, die mit der ersten Öffnung in Verbindung steht;
eine erste Elektrode (220), die die erste Öffnung füllt und Phosphor und Nickelsilicid umfasst; eine zweite Elektrode (320), die auf der ersten Elektrode gebildet ist, füllt die zweite Öffnung und umfasst Phosphor und Nickel;
eine Vorderseitenelektrode (400), die an der zweiten Elektrode gebildet ist und Silber (Ag) umfasst; und
eine Rückseitenelektrode (500), die sich auf der Rückseite des Substrats befindet, wobei die erste Öffnung 5 bis 10 nm einer Dicke der Emitterschicht freilegt,
wobei die Emitterschicht Phosphor als eine Verunreinigung umfasst und die erste Elektrode Phosphor in einer höheren Konzentration als die Emitterschicht umfasst.

2. Solarzelle nach Anspruch 1, wobei die Emitterschicht (200) einen Schichtwiderstand von 60 bis 120 Ω/Quadrat und eine Dicke von 100 bis 500 nm aufweist.

3. Solarzelle nach Anspruch 1, wobei die Rückseitenelektrode (500) Aluminium umfasst.

4. Verfahren zur Herstellung einer Solarzelle, das folgende Schritte umfasst:
Bilden einer Emitterschicht (200) des zweiten Leitfähigkeitstyps auf der Oberseite eines Substrats (100) des ersten Leitfähigkeitstyps;
Bilden eines Antireflexionsfilms (300) auf der Oberseite der Emitterschicht;
Entfernen von Teilen des Antireflexionsfilms und der Emitterschicht, um eine erste Öffnung (210), die eine Dicke der Emitterschicht von 5 bis 10 nm freilegt, und eine zweite Öffnung (310), die mit der ersten Öffnung in Verbindung steht und einen Teil des Antireflexionsfilms freilegt, zu bilden;
Siebdrucken einer phosphordotierten Nickelnanopartikel-haltigen Paste in den ersten und zweiten Öffnungen und Erhitzen derselben, um erste (220) und zweite Elektroden (320) in der ersten bzw. zweiten Öffnung zu bilden,
wobei die erste Elektrode Phosphor und Nickelsilicid umfasst und die zweite Elektrode Phosphor und Nickel umfasst;
Siebdrucken einer Silberpaste auf die zweite Elektrode und Erhitzen derselben, um eine Vorderseitenelektrode (400) zu bilden, die Silber (Ag) umfasst; und
Aufdrucken einer Aluminiumpaste auf die Rückseite des Substrats und Erhitzen derselben, um eine Rückseitenelektrode (500) zu bilden,
wobei die Emitterschicht Phosphor als eine Verunreinigung umfasst und die erste Elektrode Phosphor in einer höheren Konzentration als die Emitterschicht umfasst.

5. Verfahren zur Herstellung einer Solarzelle nach Anspruch 4, wobei die phosphordotierte Nickelnanopartikel-haltige Paste 60 bis 95 Gewichtsteile des phosphordotierten Nickelnanopartikels, 1 bis 20 Gewichtsteile eines Bindemittels und 1 bis 20 Gewichtsteile eines Lösungsmittels, bezogen auf 100 Teile nach Gewicht der Paste umfasst.

6. Verfahren zur Herstellung einer Solarzelle nach Anspruch 5, wobei der phosphordotierte Nickelnanopartikel einen durchschnittlichen Teilchendurchmesser von 5 bis 200 nm aufweist.

7. Verfahren zur Herstellung einer Solarzelle nach Anspruch 5, wobei der phosphordotierte Nickelnanopartikel Phosphor in der Menge von 1 bis 20 Gew.-% umfasst, bezogen auf das Gesamtgewicht des Nickelnanopartikels.

8. Verfahren zur Herstellung einer Solarzelle nach Anspruch 4, wobei die Silberpaste keine Glasfritte umfasst.

9. Verfahren zur Herstellung einer Solarzelle nach Anspruch 4, wobei die Emitterschicht (200) den Schichtwiderstand von 60 bis 120 Ω/Quadrat und eine Dicke von 100 bis 500 nm aufweist.

10. Verfahren zur Herstellung einer Solarzelle nach Anspruch 4, wobei der Schritt der Wärmebehandlung der phosphordotierten Nickelnanopartikel-haltigen Paste und der Schritt der Wärmebehandlung der Silberpaste gleichzeitig durchgeführt werden.

11. Verfahren zur Herstellung einer Solarzelle nach Anspruch 10, wobei der Schritt der Wärmebehandlung durch Brennen für 10 Sekunden bis 20 Minuten bei der Temperatur von 400 bis 900 °C durchgeführt wird.

## Revendications

1. Une cellule solaire qui comprend :
un premier substrat de type conducteur (100) ;
une deuxième couche émettrice de type conducteur (200) qui est située sur le substrat et présente une première ouverture (210) ;
un film antireflet (300) qui est situé sur la couche émettrice et présente une deuxième ouverture (310) communiquant avec la première ouverture ;
une première électrode (220) qui remplit la première ouverture et comprend du phosphore et du siliciure de nickel,
une deuxième électrode (320) qui est formée sur la première électrode, remplit la deuxième ouverture et comprend du phosphore et du nickel ;
une électrode avant (400) qui est formée sur la deuxième électrode et contient de l'argent (Ag), et
une électrode arrière (500) qui est située sur l'arrière du substrat,
la première ouverture exposant 5 à 10 nm d'une épaisseur de la couche émettrice,
la couche émettrice contenant du phosphore en tant qu'impureté, et la première électrode contient du phosphore à une concentration plus élevée que la couche émettrice.

2. La cellule solaire selon la revendication 1, dans laquelle la couche émettrice (200) a la résistance de feuille de 60 à 120 Ω/sq et l'épaisseur de 100 à 500 nm.

3. La cellule solaire selon la revendication 1, dans laquelle l'électrode arrière (500) contient de l'aluminium.

4. Un procédé de préparation d'une cellule solaire comprenant les étapes consistant à :
former une deuxième couche émettrice de type conducteur (200) sur le dessus d'un premier substrat de type conducteur (100) ;
former un film antireflet (300) sur le dessus de la couche émettrice ;
retirer des parties du film antireflet et de la couche émettrice pour former une première ouverture (210) qui expose 5 à 10 nm d'une épaisseur de la couche émettrice et une deuxième ouverture (310) qui communique avec la première ouverture et expose une partie du film antireflet ;
sérigraphier une pâte contenant des nanoparticules de nickel dopé au phosphore dans les première et deuxième ouvertures et la chauffer pour former une première (220) et
une deuxième (320) électrodes dans les première et deuxième ouvertures respectivement,
la première électrode comprenant du phosphore et du siliciure de nickel et la deuxième électrode comprenant du phosphore et du nickel ;
sérigraphier une pâte d'argent sur la deuxième électrode et la chauffer pour former une électrode avant (400) contenant de l'argent (Ag) ; et
imprimer une pâte d'aluminium sur l'arrière du substrat et la chauffer pour former une électrode arrière (500),
la couche émettrice contenant du phosphore en tant qu'impureté, et la première électrode contenant du phosphore en concentration plus élevée que la couche émettrice.

5. Le procédé de préparation d'une cellule solaire selon la revendication 4, dans lequel la pâte contenant des nanoparticules de nickel dopé au phosphore comprend 60 à 95 parties en poids des nanoparticules de nickel dopé au phosphore, 1 à 20 parties en poids d'un liant et 1 à 20 parties en poids d'un solvant, sur la base de 100 parties en poids de la pâte.

6. Le procédé de préparation d'une cellule solaire selon la revendication 5, dans lequel la nanoparticule de nickel dopé au phosphore a un diamètre de particule moyen de 5 à 200 nm.

7. Le procédé de préparation d'une cellule solaire selon la revendication 5, dans lequel la nanoparticule de nickel dopé au phosphore contient du phosphore en quantité de 1 à 20 % en poids sur la base du poids total de la nanoparticule de nickel.

8. Le procédé de préparation d'une cellule solaire selon la revendication 4, dans lequel la pâte d'argent ne contient pas de fritte de verre.

9. Le procédé de préparation d'une cellule solaire selon la revendication 4, dans lequel la couche émettrice (200) a la résistance de feuille de 60 à 120 Ω/sq et l'épaisseur de 100 à 500 nm.

10. Le procédé de préparation d'une cellule solaire selon la revendication 4, dans lequel l'étape de traitement par la chaleur de la pâte contenant des nanoparticules de nickel dopé au phosphore et l'étape de traitement par la chaleur de la pâte d'argent sont exécutées simultanément.

11. Le procédé de préparation d'une cellule solaire selon la revendication 10, dans lequel le traitement par la chaleur est réalisé par une cuisson pendant 10 s à 20 mn à la température de 400 à 900 °C.
